# FASCICULE DE BREVET EUROPEEN

(11) **EP 1 435 691 B1**
(45) Date de publication et mention de la délivrance du brevet: **26.07.2006**
(21) Numéro de dépôt: 03300275.9
(22) Date de dépôt: 22.12.2003
(51) Int. Cl.: H03K 17/72

(54) **Circuit de commande d'un triac sans isolement galvanique**
Schaltungsanordnung zur Steuerung eines Triacs ohne galvanische Trennung
Triac control circuit without galvanic isolation

(30) Priorité: 27.12.2002 FR 0216802
(43) Date de publication de la demande: 07.07.2004
(73) Titulaire: STMicroelectronics S.A., 92120 Montrouge (FR)
(72) Inventeur: Gonthier, Laurent, 37000 Tours (FR); Peron, Benoît, 37000 Tours (FR)
(74) Mandataire: de Beaumont, Michel

(56) Documents cités:
- DE-A- 3 148 115
- FR-A- 1 576 919
- FR-A- 2 166 512
- US-A- 3 547 348
- US-A- 3 798 462
- US-A- 4 336 464

## Description

La présente invention concerne de façon générale la commande d'un interrupteur bidirectionnel par un circuit de commande, tel qu'un microprocesseur, dans le cas où le circuit de commande n'est pas référencé à la même tension de référence que celle de la borne de commande de l'interrupteur bidirectionnel.

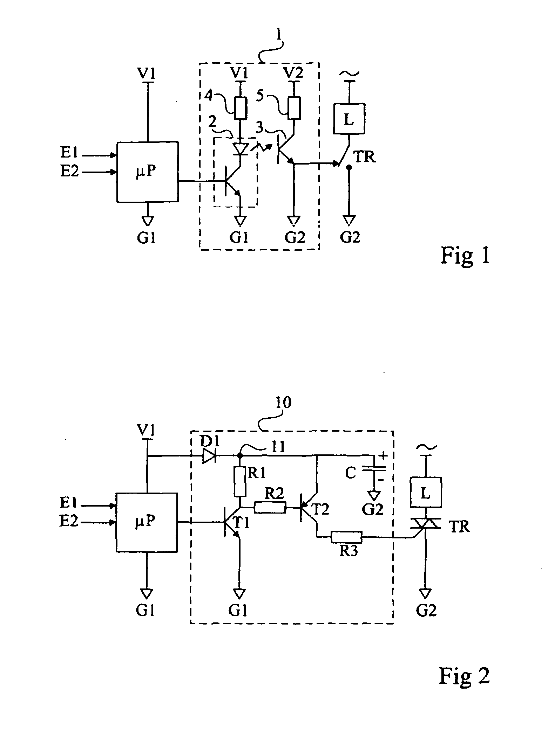

Comme l'illustre la figure 1, il existe de nombreux cas dans lesquels un circuit de commande µP alimenté entre une première tension V1 et une première tension de référence ou première masse G1, est destiné à commander un interrupteur bidirectionnel TR référencé à une deuxième tension de référence ou masse G2. L'interrupteur bidirectionnel TR est par exemple destiné à commuter une charge L alimentée par le réseau d'alimentation alternative (couramment à 50 ou 60 Hz). Il est nécessaire de prévoir un circuit d'isolement entre le circuit de commande et l'interrupteur bidirectionnel. On utilise couramment un circuit d'isolement galvanique 1 tel qu'un opto-coupleur comprenant un photoémetteur 2 et un photorécepteur 3. Le photoémetteur 2, par exemple une photodiode en série avec un transistor, est connecté entre la tension d'alimentation V1 du circuit de commande et la masse G1 du circuit de commande. Le photorécepteur 3, tel qu'un phototransistor, est alimenté entre une tension d'alimentation V2 dérivée de la tension alternative appliquée à la charge et la masse G2. Une résistance 4 est disposée en série entre la tension V1 et le collecteur du transistor 2. Une impédance 5 est connectée entre le phototransistor 3 et la tension V2. Quand le transistor 3 est commandé à l'état passant, le commutateur TR est commandé.

Bien que le circuit d'isolement galvanique 1 soit illustré en figure 1 comme un photocoupleur, ce circuit d'isolement galvanique pourra également être réalisé sous forme d'un transformateur d'isolement, par exemple un transformateur d'impulsions.

De façon générale, un circuit d'isolement galvanique est un circuit coûteux et bien souvent impossible à intégrer.

Un objet de la présente invention est donc de prévoir la commande d'un interrupteur bidirectionnel, et plus particulièrement d'un interrupteur bidirectionnel commandable en courant, par un circuit de commande non référencé au même potentiel de référence que l'interrupteur à commander sans qu'il soit nécessaire d'utiliser un circuit d'isolement galvanique.

Un objet plus particulier de la présente invention est de prévoir un circuit de commande d'un relais électromagnétique.

Pour atteindre ces objets, la présente invention prévoit un circuit de commande d'un interrupteur bidirectionnel référencé à une première tension de référence par un circuit de commande alimenté par une première tension et référencé à une deuxième tension de référence distincte de la première tension de référence. La tension d'alimentation du circuit de commande est connectée par une diode à un circuit de couplage comprenant un noeud, ce noeud étant relié :
- par l'intermédiaire d'une première impédance, au collecteur d'un transistor NPN dont l'émetteur est relié à la deuxième tension de référence et dont la base reçoit la sortie du circuit de commande,
- à une première borne d'un condensateur dont la deuxième borne est reliée à la première tension de référence,
- à l'émetteur d'un transistor PNP dont la base est reliée au collecteur du transistor par l'intermédiaire d'une deuxième impédance, et dont le collecteur est relié à la borne de commande de l'interrupteur bidirectionnel.

Selon un mode de réalisation de la présente invention, le collecteur du deuxième transistor est relié à la borne de commande de l'interrupteur bidirectionnel par l'intermédiaire d'une résistance de limitation du courant de commande.

La présente invention vise aussi un circuit de commande d'un relais électromagnétique de commande d'une charge par une tension alternative, comprenant un transformateur qui alimente, d'une part, une bobine de commande en série avec un commutateur bidirectionnel à commande en courant et, d'autre part, par l'intermédiaire d'un redresseur, un circuit de commande dudit commutateur, dans lequel le couplage entre le circuit de commande et le commutateur bidirectionnel est tel que susmentionné.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 illustre un circuit de commande d'interrupteur à isolement galvanique ;
la figure 2 illustre un circuit de commande d'un commutateur bidirectionnel à commande en courant selon la présente invention ;
la figure 3 représente un mode de réalisation particulier d'un circuit de commande de triac de l'art antérieur ;
la figure 4 représente un mode de réalisation particulier d'un circuit de commande de triac selon la présente invention ;
la figure 5 représente un circuit de commande d'un relais électromagnétique selon l'art antérieur ; et
la figure 6 représente un circuit de commande d'un relais électromagnétique selon la présente invention.

La figure 2 représente un mode de réalisation particulier d'un circuit de commande d'interrupteur bidirectionnel selon la présente invention. Un circuit de commande, tel qu'un microprocesseur µP recevant des instructions de commande sur une ou plusieurs bornes d'entrée E1, E2, est alimenté entre une tension continue positive V1 et un premier potentiel G1, qui sera également appelé masse G1. Un triac ou autre commutateur bidirectionnel à commande en courant TR en série avec une charge L est alimenté entre une source de tension alternative et une deuxième tension de référence G2 ou masse G2.

La présente invention prévoit un circuit de couplage 10 comprenant un transistor NPN T1 dont la base reçoit la sortie du microprocesseur µP, dont l'émetteur est connecté à la masse G1 et dont le collecteur est connecté à la tension d'alimentation V1 par l'intermédiaire d'une résistance R1. Une diode D1 est interposée entre la résistance R1 et la tension d'alimentation V1. Le point de connexion de la diode D1 et de la résistance R1 constitue un noeud 11 du circuit. Le collecteur du transistor T1 est connecté par l'intermédiaire d'une résistance R2 à la base d'un transistor PNP T2 dont l'émetteur est connecté au noeud 11. A ce noeud 11 est également connectée une première borne d'un condensateur C dont la deuxième borne est reliée à la deuxième tension de référence G2. Le collecteur du transistor T2 est relié, de préférence par l'intermédiaire d'une faible résistance R3, à la gâchette du triac TR.

Le fonctionnement du circuit de couplage 10 est le suivant. Quand le microprocesseur envoie un ordre de fermeture au triac TR, le transistor T1 devient passant ce qui provoque la mise en conduction du transistor T2. Le condensateur C qui a été préalablement chargé se décharge alors par le transistor T2, la résistance R3 et le circuit de gâchette du triac TR vers la deuxième tension de référence G2, ce qui entraîne la mise en conduction du triac. La résistance R3 sert à limiter le courant de commande, et est choisie pour que la durée de décharge du condensateur C soit suffisante, par exemple pour que le triac se déclenche même si l'ordre de fermeture arrive au voisinage d'un passage à zéro de la tension alternative appliquée à la charge.

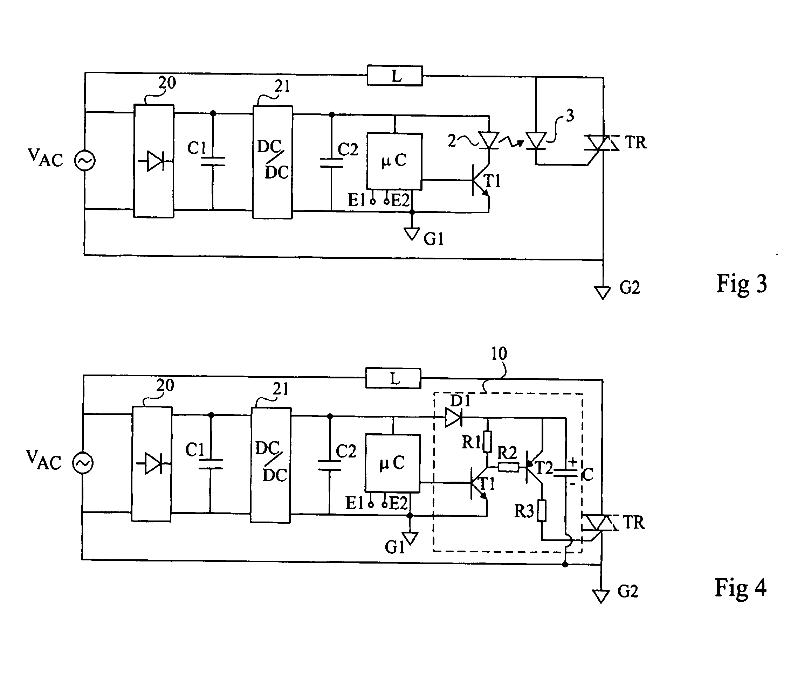

Les figures 3 et 4 représentent de façon plus détaillée, respectivement un circuit selon l'art antérieur et un circuit selon la présente invention, de commande d'un triac alimenté par le réseau alternatif, le microcontrôleur étant alimenté par une tension redressée dérivée de ladite tension alternative. Dans les figures 3 et 4, de mêmes éléments qu'en figures 1 et 2 sont désignés par de mêmes références.

Comme l'illustre la figure 3, une tension alternative VAC est reliée aux bornes d'une charge L et d'un triac TR. Cette tension alternative est également appliquée à un pont redresseur 20 dont la sortie est couplée à un condensateur de stockage C. Eventuellement, la tension aux bornes du condensateur alimente un condensateur C2 disposé de l'autre côté d'un convertisseur continu-continu 21 destiné à l'alimentation du microcontrôleur µC. Le microcontrôleur µC commande un transistor T1 en série avec une diode photoémettrice 2 couplée à une diode photo-réceptrice 3.

La figure 4 représente le même circuit que celui de la figure 3 mais dans lequel l'opto-coupleur est remplacé par un circuit de couplage 10 selon la présente invention portant les mêmes références que le circuit de la figure 2.

La présente invention présente un intérêt tout particulier dans le cas où l'on veut commander une charge par l'intermédiaire d'un relais.

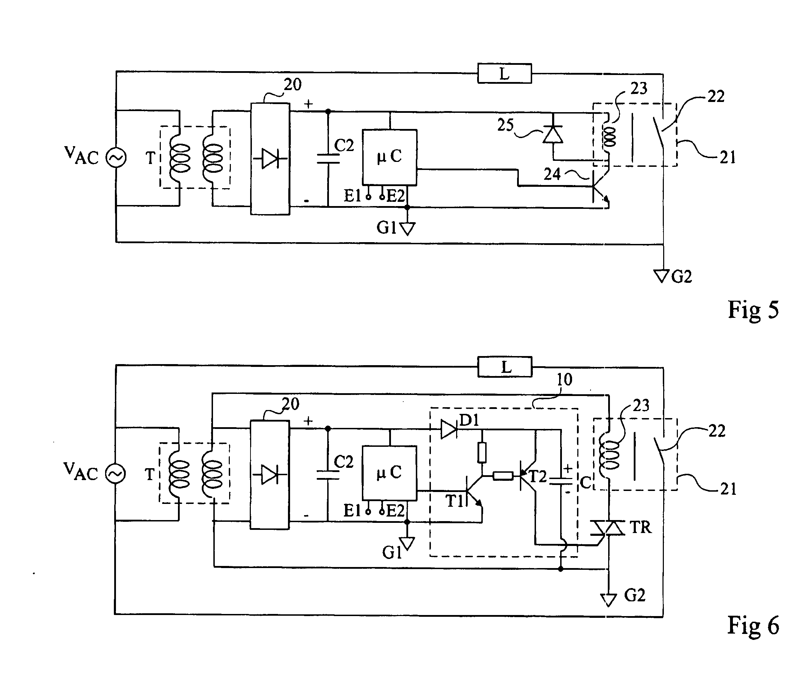

La figure 5 représente un circuit classique de commande d'un relais. Un microcontrôleur µC recevant des entrées E1 et E2 est alimenté à partir d'une tension alternative, par exemple par l'intermédiaire d'un transformateur T alimentant un pont redresseur 20 fournissant une tension lissée aux bornes d'un condensateur C2. Un relais 21 est connecté en série avec une charge L aux bornes de la tension d'alimentation alternative VAC. Le relais 21 comprend un commutateur 22 commandé par une bobine 23. De façon classique, cette bobine 23 est connectée en série avec un transistor 24 aux bornes du condensateur C2, et la mise en conduction du transistor 24 est assurée par la sortie du microcontrôleur µC. Une diode roue libre 25 est placée en parallèle sur la bobine 13, pour protéger le transistor 24 lors des phases d'ouverture.

Ainsi, de façon classique, la bobine 23 est commandée en continu. Ceci entraîne divers inconvénients. En effet, sous une alimentation continue, l'impédance de la bobine est en première approximation réduite à sa seule partie réelle, c'est-à-dire sa résistance. Or cette résistance est en général faible. Le courant nécessaire pour obtenir l'énergie magnétique requise pour une activation du relais 11 est alors élevé, de l'ordre de 20 à 200 mA.

Plus le courant devant passer dans la bobine est élevé, plus les dimensions du transformateur T sont importantes, ce qui rend difficile son intégration. Ceci est accentué par le fait que le facteur de puissance d'un pont de diodes est classiquement de 0,5, d'où il résulte que le courant apparent est le double du courant actif.

De plus, avec un courant de bobine élevé, les pertes par effet Joule dans les enroulements sont élevées.

En outre, plus le courant nécessaire est important, plus la capacité du condensateur C2 doit être élevée pour limiter les écarts de tension. Cela conduit à utiliser une capacité de l'ordre de la centaine de microfarads et donc un condensateur encombrant.

Un autre inconvénient d'une telle commande d'un relais 21 par un courant continu réside dans le fait que, lors du passage du courant continu dans la bobine 23, il se crée un champ magnétique entre la bobine 23 et la lame 22 qu'elle commande, champ qui disparaît peu de temps après l'allumage avec la stabilisation du courant. Il faut alors prévoir un dispositif spécifique (non représenté) de blocage de la lame 12 en position fermée.

La présente invention prévoit de modifier le circuit classique de la figure 5 en alimentant en alternatif la bobine 13 et en utilisant un circuit de couplage 12 tel que décrit précédemment en relation avec les figures 2 et 4.

Ainsi, la présente invention prévoit, comme le représente la figure 6, de connecter les bornes de la bobine du relais non pas à la sortie du redresseur 20 mais directement au secondaire du transformateur T, en série avec un triac TR. Le circuit de couplage 10 selon la présente invention permet de résoudre les problèmes d'isolement galvanique posés par la commande du triac TR lié à un potentiel de référence G2 distinct du potentiel de référence G1 du circuit de commande µC.

Ainsi, on résout au moyen d'un circuit simple les inconvénients de l'état de la technique. En effet, la bobine 23 étant alimentée par un courant alternatif, son impédance est plus élevée que dans le cas où elle est alimentée par un courant continu. Pour obtenir l'énergie électromagnétique requise pour une activation de relais, le courant dans la bobine peut être plus faible. En pratique, ce courant est réduit d'un facteur 3 à 5. Ceci permet de réduire la dimension du transformateur T et la capacité du condensateur C2. On élimine en outre la nécessité de prévoir un dispositif supplémentaire permettant le blocage de la lame du relais.

La présente invention a été exposée de façon générale en relation avec la figure 2, de façon plus détaillée en relation avec la figure 4, et dans le cadre d'une application particulière avec la figure 6. On notera qu'elle s'applique de façon générale dans tous les cas où l'on veut commander un interrupteur bidirectionnel à commande en courant au moyen d'un circuit de commande dont la référence de tension est distincte de la référence de tension du circuit alternatif d'alimentation.

La présente invention s'applique également à la commande d'un interrupteur bidirectionnel à commande en tension.

## Revendications

1. Circuit de commande d'un interrupteur bidirectionnel (TR) référencé à une première tension de référence (G2) par un circuit de commande (µC) alimenté par une première tension (V1) et référencé à une deuxième tension de référence (G1) distincte de la première tension de référence (G2), **caractérisé en ce que** la tension d'alimentation (V1) du circuit de commande est connectée par une diode (Dl) à un circuit de couplage (10) comprenant un noeud (11), ce noeud étant relié :
- par l'intermédiaire d'une première impédance (R1), au collecteur d'un transistor NPN (T1) dont l'émetteur est relié à la deuxième tension de référence (G1) et dont la base reçoit la sortie du circuit de commande,
- à une première borne d'un condensateur (C) dont la deuxième borne est reliée à la première tension de référence (G2),
- à l'émetteur d'un transistor PNP (T2) dont la base est reliée au collecteur du transistor (T1) par l'intermédiaire d'une deuxième impédance (R2), et dont le collecteur est relié à la borne de commande de l'interrupteur bidirectionnel (TR).

2. Circuit selon la revendication 1, dans lequel le collecteur du deuxième transistor (T2) est relié à la borne de commande de l'interrupteur bidirectionnel (TR) par l'intermédiaire d'une résistance (R3) de limitation du courant de commande.

3. Circuit de commande d'un relais électromagnétique (11) de commande d'une charge (L) par une tension alternative (VAC), comprenant un circuit selon la revendication 1 et un transformateur (T) qui alimente, d'une part, une bobine de commande (23) en série avec l'interrupteur bidirectionnel (TR) à commande en courant et, d'autre part, par l'intermédiaire d'un redresseur (20), le circuit de commande (µC) dudit interrupteur (TR), ledit redresseur (20) produisant la première tension (V1).

## Claims

1. A circuit for controlling a bidirectional switch (TR) referenced to a first reference voltage (G2) by a control circuit (µC) supplied by a first voltage (V1) and referenced to a second reference voltage (G1), different from the first reference voltage (G2), **characterized in that** the supply voltage (V1) of the control circuit is connected by a diode (D1) to a coupling circuit (10) comprising a node (11), this node being connected:
- via a first impedance (R1), to the collector of an NPN transistor (T1) having its emitter connected to the second reference voltage (G1) and having its base receiving the output of the control circuit,
- to a first terminal of a capacitor (C) having its second terminal connected to the first reference voltage (G2),
- to the emitter of a PNP transistor (T2) having its base connected to the collector of the transistor (T1) via a second impedance (R2), and having its collector connected to the control terminal of the bidirectional switch (TR).

2. The circuit of claim 1, wherein the collector of the second transistor (T2) is connected to the control terminal of the bidirectional switch (TR) via a control current limiting resistor (R3).

3. A circuit for controlling an electromagnetic relay (11) of control of a load (L) with an A.C. voltage (VAC), comprising a circuit according to claim 1 and a transformer (T) which supplies, on the one hand, a control coil (23) in series with the current-controlled bidirectional switch (TR) and, on the other hand, through a rectifier (20), the circuit (µC) for controlling said switch (TR), said rectifier (20) providing the first voltage (V1).

## Patentansprüche

1. Steuerschaltung für einen bi-direktionalen Schalter (TR), in Bezug stehend mit einer ersten Bezugsspannung (G2) durch eine Steuerschaltung (µC), versorgt durch eine erste Spannung (V1) und in Bezug stehend mit einer zweiten Bezugsspannung (G1), die sich von der ersten Bezugsspannung (G2) unterscheidet, **dadurch gekennzeichnet, dass** die Versorgungsspannung (V1) der Steuerschaltung durch eine Diode D1 mit einer Koppelschaltung (10) verbunden ist, die einen Knoten (11) aufweist, wobei dieser Knoten mit Folgendem verbunden ist:
- über eine erste Impedanz (R1) mit dem Kollektor eines npn-Transistors (T1) dessen Emitter mit der zweiten Bezugsspannung (G1) verbunden ist, und dessen Basis die Ausgangsgröße der Steuerschaltung empfängt,
- mit einem ersten Anschluss eines Kondensators (C), dessen zweiter Anschluss mit der ersten Bezugsspannung (G2) verbunden ist,
- mit dem Emitter eines pnp-Transistors (T2), dessen Basis mit dem Kollektor des Transistors (T1) über eine zweite Impedanz (R2) verbunden ist, und dessen Kollektor mit dem Steueranschluss des bi-direktionalen Schalters (TR) verbunden ist.

2. Schaltung nach Anspruch 1, wobei der Kollektor des zweiten Transistors (T2) mit dem Steueranschluss des bi-direktionalen Schalters (TR) über einen Steuerstrombegrenzungswiderstand (R3) verbunden ist.

3. Schaltung zur Steuerung eines elektromagnetischen Relais (11) zur Steuerung einer Last (L) mit einer Wechselspannung (VAC), wobei Folgendes vorgesehen ist:
eine Schaltung gemäß Anspruch 1 und ein Transformator (T), der einerseits eine Steuerspule (23) in Serie mit dem stromgesteuerten bi-direktionalen Schalter (TR) und andererseits über einen Gleichrichter (20), die Schaltung (µC) für die Steuerung des erwähnten Schalters (TR) versorgt, wobei der Gleichrichter (20) die erste Spannung (V1) vorsieht.
